# EUROPÄISCHE PATENTSCHRIFT

(11) **EP 0 530 640 B1**
(45) Veröffentlichungstag und Bekanntmachung des Hinweises auf die Patenterteilung: **17.04.1996**
(21) Anmeldenummer: 92114441.6
(22) Anmeldetag: 25.08.1992
(51) Int. Cl.: H01J 37/153, H01J 37/10, H01J 3/12

(54) **Abbildungssystem für Strahlung geladener Teilchen mit Spiegelkorrektor**
Imaging system with mirror corrector for charged particle radiation
Système de formation d'images de faisceau de particules chargées avec miroir correcteur

(30) Priorität: 04.09.1991 DE 4129403
(43) Veröffentlichungstag der Anmeldung: 10.03.1993
(73) Patentinhaber: Firma Carl Zeiss, D-73446 Oberkochen (DE); CARL-ZEISS-STIFTUNG, HANDELND ALS CARL ZEISS, D-73446 Oberkochen (DE)
(72) Erfinder: Rose, Harald, Prof. Dr., W-6100 Darmstadt (DE); Preikszas, Dirk, W-8750 Aschaffenburg (DE); Degenhardt, Ralf, W-6050 Offenbach/M. (DE)

(56) Entgegenhaltungen:
- REVUE DE PHYSIQUE APPLIQUEE Bd. 6, 1971, PARIS FR Seiten 65 - 89 LELEYTER ET AL. 'ETUDE DES ABERATIONS DU SECOND ORDRE DU MICROANALYSEUR IONIQUE ET DE QUELQUES AUTRES SYSTEMES DESTINES AU FILTRAGE D'IMAGES ETENDUES'
- OPTIK Bd. 87, Nr. 1, 1991, STUTTGART DE Seiten 1 - 12 KOLARIK ET AL. 'CLOSE PACKED PRISM ARRAY FOR ELECTRON MICROSCOPY'
- REVIEW OF SCIENTIFIC INSTRUMENTS Bd. 61, April 1990, NEW YORK US Seiten 1230 - 1235 ZHIFENG SHAO ET AL. "PROPERTIES OF A FOUR-ELECTRODE ADJUSTABLE ELECTRON MIRROR AS AN ABERRATION CORRECTOR"

## Beschreibung

Die Erfindung betrifft ein Abbildungssystem für Strahlung geladener Teilchen, insbesondere in einem Teilchenstrahlmikroskop, nach dem Oberbegriff des Anspruchs 1.

Die Erzeugung von ionen- oder elektronenoptischen Abbildungssystemen, die bezüglich ihrer chromatischen Aberration korrigiert sind, ist verglichen mit der Lichtoptik kompliziert. Denn die zur Abbildung verwendeten magnetischen Rundlinsen weisen immer positive Farbfehler auf. Eine Korrektur solcher Abbildungssysteme durch Hintereinanderschaltung mehrerer Linsen ist daher nicht möglich.

Aus Optik, Band 85, Seite 19, 1990 ist es bekannt, Öffnungsfehler eines elektronenoptischen Systems durch zwei magnetische Doubletsysteme und einem auf jedes Doublet folgenden magnetischen Hexapolelement zu korrigieren. Zwar ist es grundsätzlich auch möglich, durch Oktupole und kombinierte elektrisch-magnetische Quadrupolelemente eine gleichzeitige Korrektur von Öffnungs- und Farbfehlern zu erzielen, jedoch sind dann sehr hohe Anforderungen an die Stabilität der Quadrupolfelder sowie an die Justierung der Multipole, zu stellen.

Außerdem ist es auch bekannt, den Farb- und Öffnungsfehler gleichzeitig durch Verwendung elektrostatischer Spiegel zu korrigieren, da Farb- und Öffnungsfehler von elektrostatischen Spiegeln negativ sein können. Ein entsprechendes Abbildungssystem ist beispielsweise in Journal of Applied Physics, Band 67, 6027, (1990) beschrieben. Für solche Spiegelkorrektive ist ein Strahlumlenker erforderlich, der den vom Objektiv kommenden Elektronenstrahl zum Spiegel umlenkt, und den am Spiegel reflektierten Elektronenstrahl zum Beobachtungsstrahlengang lenkt. Magnetische Strahlumlenker verursachen in der Regel selbst Fehler 2. Ordnung, da sie nicht rotationssymmetrisch sind. Zur Vermeidung dieser zusätzlichen Fehler ist in der zitierten Literaturstelle vorgeschlagen, daß die Umlenkung in Zwischenbildebenen erfolgen soll. Insgesamt wird hier ein System benötigt, daß aus drei Umlenkern mit jeweils zwischengeschalteten Relaylinsensystemen besteht, so daß das ganze Abbildungssystem sehr komplex und aufwendig ist.

Aus Optik Band 87, Seite 1, 1991 ist ein Spiegelkorrektiv gemäß dem Oberbegriff des Anspruchs 1 bekannt, bei dem ein einziger 90°-Umlenker mit fünf Sektoren unterschiedlicher Magnetfeldstärke vorgesehen ist. Die Symmetrieebenen des Umlenkers sind jeweils zugleich auch Zwischenbildebenen. Der Spiegel selbst ist in der Bildebene einer zweiten Kathodenlinse angeordnet, die hinter einer außerhalb des Umlenkers liegenden Beugungsebene angeordnet ist. Hier verbleiben nach dem zweimaligen Durchgang des Elektronenstrahls durch den Umlenker die Fehler zweiter Ordnung des Umlenkers.

Es ist die Aufgabe der vorliegenden Erfindung, ein Abbildungssystem nach dem Oberbegriff des Anspruchs 1 dahingehend zu verbessern, daß sich bei einfacher Konstruktion die chromatischen Abbildungsfehler korrigieren lassen.

Diese Aufgabe wird erfindungsgemäß dadurch gelöst, daß der Spiegel konjugiert zu den beiden Symmetrieebenen des Umlenkers angeordnet ist und die beiden Symmetrieebenen im Abbildungsmaßstab 1:1 ineinander abgebildet sind.

Da beim erfindungsgemäßen Abbildungssystem der Spiegel die beiden Symmetrieebenen aufeinander mit dem Abbildungsmaßstab 1:1 abbildet und gleichzeitig beide Symmetrieebenen in den Spiegel abgebildet sind und somit die in den Spiegel einfallenden und aus dem Spiegel austretenden Teilchenbahnen symmetrisch zur optischen Achse des Spiegels und im Umlenker symmetrisch oder antisymmetrisch zu den Symmetrieebenen verlaufen,verschwinden die Fehler zweiter Ordnung und die Dispersion nach dem zweiten Durchgang durch den Umlenker. Es verbleiben daher lediglich die negativen Farb- und Öffnungsfehler des Spiegels. Diese können nun so eingestellt werden, daß die Farb- und Öffnungsfehler anderer im Strahlengang befindlicher Elemente, z.B. Linsen oder Multipole, kompensiert sind. Der Strahlumlenker sollte also den Teilchenstrahl auf dem Weg zum Spiegel und auf dem Weg vom Spiegel zur zweiten Ebene jeweils um betragsmäßig gleiche Winkel ablenken.

Für die Abbildung der Symmetrieebenen in den Spiegel kann zwischen dem Umlenker und dem Spiegel ein verdrehungsfreies Magnetlinsensystem angeordnet sein. Durch Variation der Linsenerregung und der Spiegelspannung lassen sich dann Farb- und Öffnungsfehler über einen weiten Bereich variieren. Besonders vorzuziehen ist jedoch eine gleichzeitig als elektrostatisches Spiegel-Linsensystem wirkende Elektrodenanordnung mit einem in der Nähe einer Beugungsebene angeordneten magnetischen Hexapolelement. Ein solches elektrostatisches Spiegel-Linsensystem ist verdrehungsfrei, und die Farb- und Öffnungsfehler sind dann außerdem unabhängig von einander einstellbar.

Die Symmetrieebenen des Umlenkers sollten die optische Achse der elektrostatischen Spiegel-Linsenkombination oder des Magnetlinsensystems im halben Ablenkwinkel schneiden.

Vorzugsweise sind die Symmetrieebenen des Umlenkers zur Zwischenbildebene oder Beugungsebene eines Objektivs konjugierte Ebenen.

Das erfindungsgemäße Abbildungssystem in Reflexions-, Transmissions- und Rasterelektronenmikroskopen sowie mit Einschränkungen auch in Ionenstrahlgeräten vorteilhaft einsetzbar. Bei den elektronenmikroskopischen Anwendungen sind speziell der Energiebereich unter 100 keV besonders bevorzugt.

Der Ablenkwinkel des Strahlumlenkers sollte 90° betragen, damit die optische Achse vor und hinter dem Ablenker, wie aus Stabilitätsgründen bei Elektronenmikroskopen üblich, vertikal verlaufen kann.

Ein solcher Ablenker mit einer vierzähligen Symmetrie der Polschuhanordnung in Ebenen senkrecht zum Magnetfeld kann gleichzeitig auch zur Trennung von Beleuchtungs- und Beobachtungsstrahlengang bei Aufbeleuchtung dienen.

Vorzugsweise erzeugt der Strahlumlenker ein äußeres Magnetfeld zur Richtungsaufspaltung der Teilchenbahnen und mindestens ein zweites Magnetfeld. Die Felder sind dann so eingestellt, daß der Umlenker gleichzeitig wie eine Feldlinse die Zwischenbildebenen der im Strahlengang befindlichen Linsen stigmatisch ineinander abbildet.

Ein Umlenker mit zwei Magnetfeldern, die gleichgerichtet, jedoch vom Betrag unterschiedlich sind, und dessen Symmetrieebenen zur Beugungsebene eines Objektivs konjugiert sind, ist für Rasterelektronenmikroskope gut geeignet. Solche aus zwei Segmenten bestehenden Umlenker sind sehr einfach. Die durch Wechselwirkung der nach einem Durchgang durch den Umlenker noch vorhandenen Dispersionsfehler des Umlenkers mit den Bildfehlern des Spiegels verursachten Kombinationsfehler zweiter und dritter Stufe verschwinden für axiale Strahlen und sind deshalb unschädlich.

Für die Korrektur von Abbildungsfehlern in abbildenden Systemen, bei denen die Korrektur über ein großes Bildfeld gewünscht ist, sind Umlenker mit zwei oder drei magnetischen Ablenkfeldern und eventuell zusätzlich überlagerten elektrostatischen Ablenkfeldern vorzuziehen. Solche Umlenker sind zwar recht komplex, können dafür aber auch für jeden einzelnen Durchgang dispersionsfrei sein. Mit Hilfe eines bereits für einen Durchgang dispersionsfreien Umlenkers und eines elektrostatischen Spiegels sind Farb- und Öffnungsfehler eines Objektivs über ein großes Bildfeld, d.h. auch für außeraxiale Strahlen, korrigierbar. Eine weitere Vergrößerung des Bildfeldes läßt sich durch Einfügen weiterer Linsen zwischen Umlenker und Spiegel erzielen, so daß zwischen Umlenker und Spiegel mindestens drei Linsen wirksam sind.

Bei einem besonders bevorzugten Ausführungsbeispiel für einen dispersionsfreien Umlenker sind dem äußeren Magnetfeld drei getrennte, betrags- und richtungsmäßig jedoch identische und dem äußeren Feld entgegengerichtete Magnetfelder überlagert, in die die Elektronen bei jedem Durchgang zweimal ein- und austreten. Die inneren Felder sind jeweils annähernd doppelt so stark wie das äußere Magnetfeld.

Die Ein- und Austrittsflächen des äußeren magnetischen Feldes sollten senkrecht zur optischen Achse liegende Ebenen bzw. Flächen bilden, die groß gegen die Querschnittsfläche des Teilchenstrahles sind, weil sonst Randquadrupole auftreten, die die hin- und rücklaufenden Elektronen unterschiedlich ablenken. Außerdem werden andere störende Einflüsse des Randfeldes vermieden, und die in einer Ebene liegenden Teilchenbahnen mit gleichem Eintrittswinkel beschreiben im äußeren Feld Bahnen mit gleichem Krümmungsradius.

Im folgenden werden Einzelheiten der Erfindung anhand der Zeichnungen näher erläutert. Im einzelnen zeigen:
- Figur 1: den schematischen Strahlengang eines erfindungsgemäßen Abbildungssystems für ein Rasterelektronenmikroskop;
- Figur 2a: eine Draufsicht auf den Strahlumlenker aus Figur 1;
- Figur 2b: eine Darstellung der fundamentalen Strahlengänge bezüglich der optischen Achse des Strahlumlenkers aus Figur 2a;
- Figur 3a: einen Schnitt durch eine elektrostatische Spiegel-linsenkombination mit vier Elektroden;
- Figur 3b: ein Diagramm des Achsenpotentials und der elektrischen Feldstärke der Spiegellinsenkombination aus Figur 3a;
- Figur 3c: ein Diagramm der Fundamentalstrahlengänge in der elektrostatischen Spiegellinsenanordnung aus Figur 3a bei vier verschiedenen Potentialkombinationen;
- Figur 4: den schematischen Strahlengang eines zweiten Ausführungsbeispiels für ein abbildendes Elektronenmikroskop;
- Figur 5a: einen Schnitt durch eine zweite elektrostatische Spiegel-Linsenkombination mit sechs Elektroden, und
- Figur 6: den schematischen Strahlengang eines weiteren Ausführungsbeispiels eines dispersionsfreien Umlenkers.

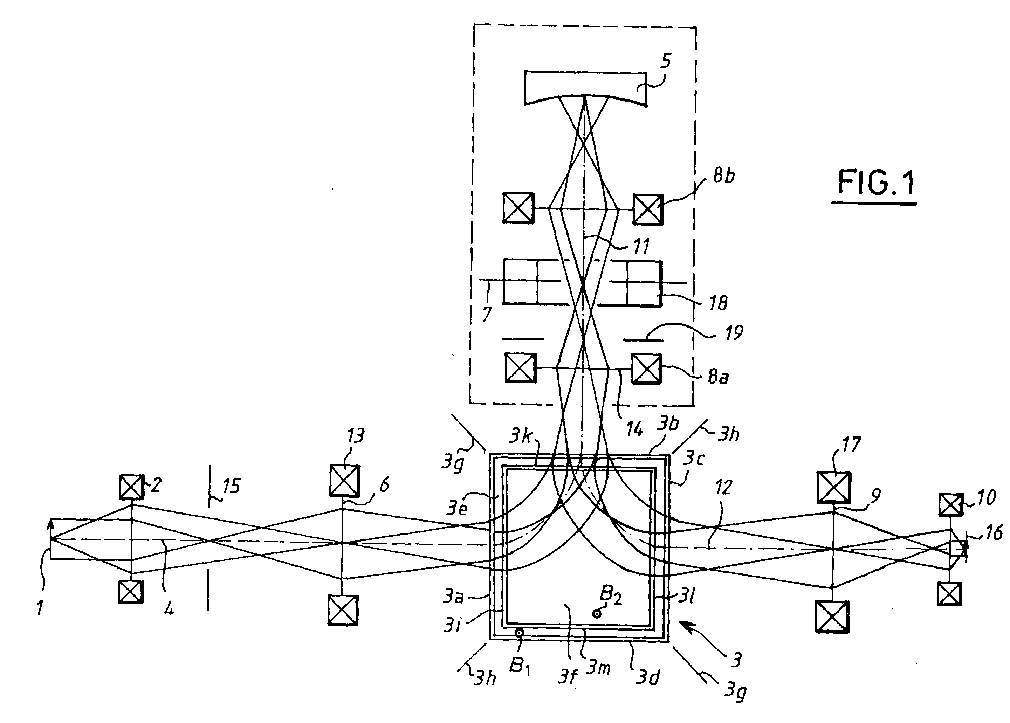

Das Rasterelektronenmikroskop nach der Figur 1 enthält eine Elektronenquelle mit einer Crossover-Ebene (1), und eine Kondensorlinse (2), die die Crossover-Ebene (1) entlang der optischen Achse (4) abbildet. Diese Elektronen treten in einer ersten Eintrittsebene (3a) in einen Strahlumlenker (3) ein. Der Strahlumlenker (3) hat einen quadratischen Querschnitt und besteht aus äußeren Polschuhen (3e) und inneren Polschuhen (3f). Zwischen den äußeren Polschuhen (3e) besteht ein äußeres Magnetfeld (B₁), und zwischen den inneren Polschuhen (3f) besteht ein inneres Magnetfeld (B₂). Beide Magnetfelder sind senkrecht zur Zeichenebene ausgerichtet, wobei das äußere Magnetfeld (B₁) stärker ist, als das innere Magnetfeld (B₂). Die Diagonalebenen (3g, 3h) sind somit Symmetrieebenen des Umlenkers (3). Die Beträge der beiden Magnetfelder (B₁, B₂) sind gerade so eingestellt, daß der Umlenker (3) die optische Achse (4) um 90° in Richtung auf einen Spiegel (5) ablenkt, und daß die hintere Zwischenbildebene (6) der Kondensorlinse (2) stigmatisch in eine Zwischenbildebene (7) zwischen dem Spiegel (5) und dem Umlenker (3) abgebildet ist. Desweiteren ist in der Zwischenbildebene (6) der Kondensorlinse eine Feldlinse (13) angeordnet, die die hintere Beugungsebene (15) der Kondensorlinse (2) in die Diagonalebene (3g) des Umlenkers abbildet.

Ein Linsensystem (8a, 8b) bildet die Diagonalebene (3g) des Umlenkers (3) in den elektrostatischen Spiegel (5) ab. Der Spiegel (5) und das Linsensystem (8a, 8b) wirken zusammen als ein Autokollimationssystem und bilden die Diagonalebene (3g) in die Diagonalebene (3h) mit dem Abbildungsmaßstab 1:1 ab. Dadurch sind die in den Spiegel (5) einfallenden und austretenden Elektronenbahnen symmetrisch zur optischen Achse (11) des Spiegelarmes.

Da der Spiegel zusammen mit dem Linsensystem (8a, 8b) rotationssymmetrisch ist, verursachen sie keinen Fehler 2. Ordnung, und die Dispersion und Fehler 2. Ordnung des nicht rotationssymmetrischen Umlenkers (3) heben sich aufgrund der Symmetrie der Strahlengänge im Umlenker (3) nach zweimaligem Durchgang auf.

In der Austrittsebene (3c) des Umlenkers treten die Elektronen entlang einer optischen Achse (12) aus, die koaxial zur optischen Achse (4) der in den Umlenker (3) eintretenden Elektronen ist. Das System aus Umlenker (3), Linsensystem (8a, b) und Spiegel (5) bildet die Zwischenbildebene (6) der Kondensorlinse (2) in die Zwischenbildebene (9) im Abbildungsmaßstab 1:1 ab. Ein Objektiv (10) bildet das hier entstehende Bild dar Crossover-Ebene (1) verkleinert mit der Zwischenvergrößerung V auf ein Objekt (16) ab. Ein nicht dargestelltes Abtastsystem dient desweiteren zur Abtastung des Objektes (16). In der objektivseitigen Zwischenbildebene (9) ist eine weitere Feldlinse (17) angeordnet, die die Symmetrieebenen (3g, 3h) in die vom Objekt (16) abgewandte Beugungsebene des Objektivs (10) abbildet.

Die Ein- und Austrittsebenen (3a, 3b, 3c, 3d) des äußeren magnetischen Feldes (B₁) sind Ebenen senkrecht zu der jeweiligen optischen Achse (4, 11, 12), so daß störende Einflüsse des Randfeldes vermieden sind. Die Ein- und Austrittsebenen (3i, 3k, 3l, 3m) des inneren Ablenkfeldes (B₂) sind zu den jeweils zugehörigen Ein-Austrittsebenen (3a, 3b, 3c, 3d) des äußeren Feldes (B₁) parallel.

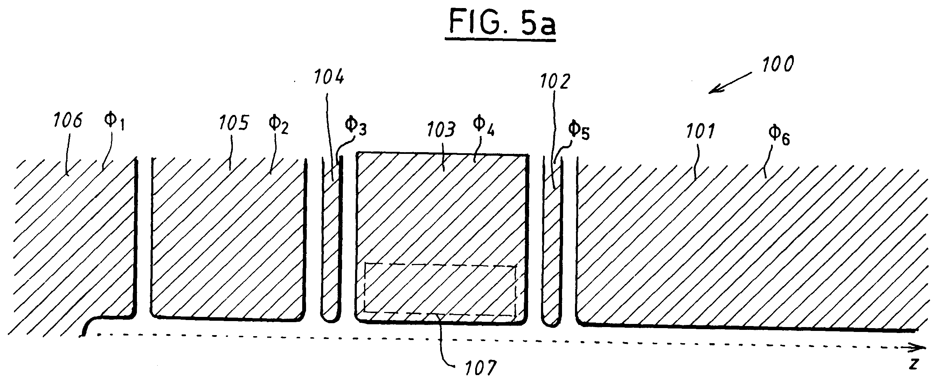

Durch geeignete Wahl der Erregung des Linsensystems (8a, b) und der Spannungen des elektrostatischen Spiegels (5) läßt sich der negative Farbfehler dieser Kombination aus Spiegel und Linsen über einen weiten Bereich derart variieren, daß der positive Farbfehler der Objektivlinse (10) kompensiert ist. Die verbleibende sphärische Aberration läßt sich dann einfach durch ein in der Beugungsebene (7) zwischen den Linsen (8a, b) und zur optischen Achse (11) zentriert angeordnetes magnetisches Hexapolelement (18) einstellen. Dieses wird zweifach durchlaufen und wirkt daher wie das in der eingangs zitierten Literaturstelle beschriebene Hexapoldouplet. Dadurch ist die Kathode (1) ohne Farb- und Öffnungsfehler auf das Objekt (16) abgebildet. Das System aus Linsen (8a, b) und Spiegel (5) kann auch durch die elektrostatischen Spiegel-Linsenkombinationen aus Figur 3a oder Figur 5a ersetzt sein.

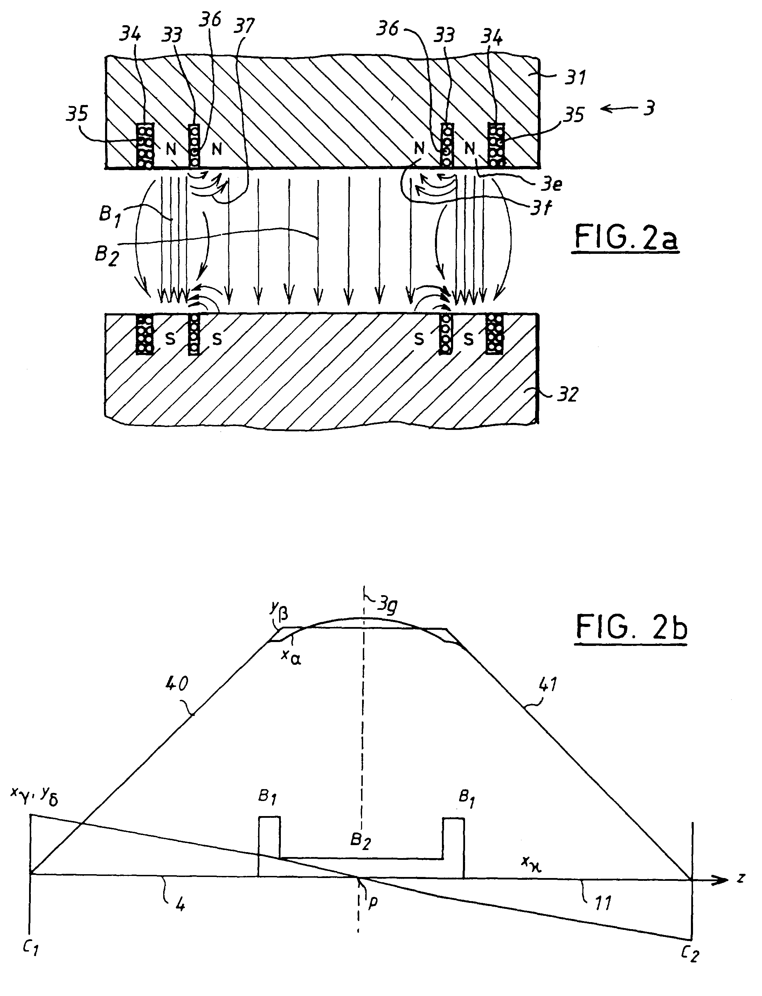

In der Figur 2a ist der Strahlumlenker (3) in einer zur Zeichenebene der Figur 1 senkrechten Schnittebene dargestellt. Er besteht aus einem oberen Polschuh (31) und einem unteren Polschuh (32). In jeden der Polschuhe sind eine innere rechteckförmige Nute (33) und eine äußere rechteckförmige Nute (34) eingefräst. In diesen beiden Nuten (33, 34) sind die Erregerspulen (35, 36) des Umlenkers aufgenommen. Die äußere Spule (35) ist relativ stark erregt, und erzeugt im Bereich zwischen den beiden Nuten (33, 34) das äußere magnetische Umlenkfeld mit der Stärke (B₁). Die inneren Spulen (36) sind schwächer und entgegengesetzt zu den äußeren Spulen (35) erregt. Dadurch entsteht in einem inneren Bereich innerhalb der Nute (33) zwischen den beiden Polschuhen (31) und (32) das schwächere innere magnetische Ablenkfeld mit der Induktion (B₂). Die Pfeile zwischen den beiden Polschuhen (31) und (32) stellen die Feldlinien der beiden magnetischen Umlenkfelder (B₁, B₂) dar, wobei der Abstand der Pfeile die Feldstärke symbolisiert.

In der Figur 2b ist der Verlauf der Fundamentalbahnen relativ zur optischen Achse dargestellt, d.h., die in der Figur 1 innerhalb des Umlenkers (3) jeweils um 90° abgelenkten optischen Achsen sind in der Figur 2b als Gerade dargestellt. Die Zwischenbildebenen vor und hinter dem Umlenker sind mit (C₁) und (C₂) bezeichnet, d.h. für ein Elektron, das in der Figur 1 aus der Kathode (1) austritt bezeichnet (C₁) die Bildebene (6) der Kondensorlinse und (C₂) die Bildebene (19) zwischen Umlenker (3) und Spiegel (5). Die Feldbahnen in der Zeichen-Ebene von Fig. 1 sind mit (x _{χ}) und die Feldbahnen in der zur Zeichen-Ebene der Fig. 1 senkrechten yz-Ebene sind mit (y _{δ} ) bezeichnet. In der Mitte des durch die beiden Umlenkfelder (B₁, B₂) gekennzeichneten Umlenkers schneiden beide Feldbahnen (x_{χ} , y_{δ} ) die optische Achse (z).

Die Aperturbahnen für ein sich in der Zeichenebene von Fig. 1 ausbreitendes Elektron ist mit (x_{α}) bezeichnet. Ein entlang einer x_{α}-Bahn fliegendes Elektron erfährt beim Eintritt in das äußere Magnetfeld (B₁) aufgrund seiner senkrecht zur optischen Achse (14) liegenden Geschwindigkeitskomponente eine Kraft in Richtung auf die optische Achse (4). Dadurch erfährt das Elektron eine Ablenkung hin zur optischen Achse (4). Im inneren Magnetfeld (B₂) erfährt dann das entlang der x_{α}-Bahn fliegende Elektron eine Ablenkung weg von der optischen Achse. Daher entfernt sich die x_{α}-Bahn im weiteren Verlauf zunächst von der optischen Achse, um dann im Bereich der Symmetrieebene (3g) parallel zur optischen Achse zu verlaufen. Hinter der Symmetrieebene (3g) nähert sich dann die x_{α}-Bahn wieder der optischen Achse an, und schneidet die optische Achse (11) im Spiegelstrahlengang im Bereich der Zwischenbildebene (C₂).

Die in einer zur Zeichenebene der Figur 1 senkrechten Ebene verlaufende y_{β} Apertur-Bahn erfährt im äußeren Magnetfeld (B₁) eine Beschleunigung in x-Richtung. Diese Geschwindigkeitskomponente bewirkt zusammen mit dem Streufeld (37) (siehe Figur 2a) beim Übergang vom äußeren Magnetfeld (B₁) ins innere Magnetfeld (B₂) eine Brechung zur optischen Achse (4) hin. Daher verläuft die y_{β}-Bahn im Bereich des inneren Magnetfeldes (B₂) parallel zur optischen Achse. Beim Übergang vom inneren Magnetfeld (B₂) zum äußeren Magnetfeld (B₁) erfährt die y_{β}-Bahn eine weitere Brechung zur optischen Achse (11) hin. Wichtig ist, daß in den Bereichen (40, 41) außerhalb des Umlenkers die x_{α} -Bahn und die y_{β}-Bahn im gleichen Winkel die optischen Achsen (4, 11) in den Zwischenbildebenen (C₁, C₂) schneiden. Denn dies bedeutet, daß die Zwischenbildebene (C₁) stigmatisch und verzeichnungsfrei im Maßstab 1:1 in die Zwischenbildebene (C₂) abgebildet wird.

Die in der Figur 3a im Schnitt dargestellte elektrostatische Spiegellinsenkombination (60), die anstelle des Spiegels (5) und der Linse (8a, 8b) in Figur 1 einsetzbar ist, besteht aus vier Elektroden (61, 62, 63, 64). Die optische Achse (z) weist in Richtung auf den hier nicht dargestellten Strahlumlenker. Die Elektroden (61, 62, 63, 64) liegen auf den elektrischen Potentialen (Φ₁, Φ₂, Φ₃, Φ₄). Das Potential (Φ₄) der dem Strahlumlenker zugewandten Elektrode (64) entspricht der kinetischen Energie der einfallenden Elektronen.

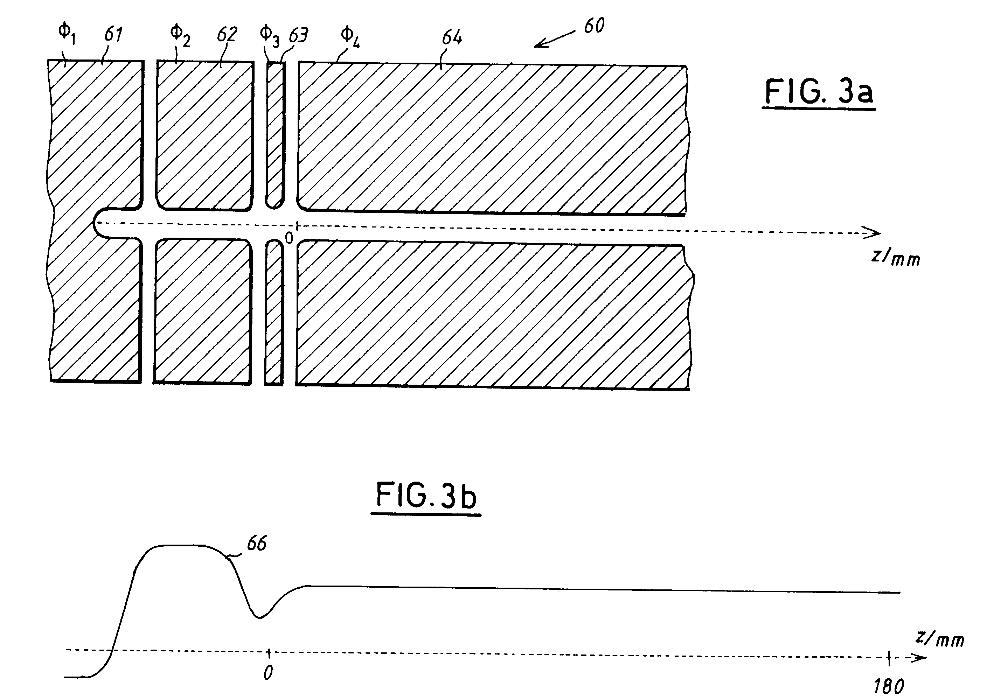

In der Figur 3b ist die Energie (66) eines sich entlang der optischen Achse (z) ausbreitenden Elektrons in der Spiegellinsenkombination (60) dargestellt. Der Verlauf der kinetischen Energie (66) bezieht sich dabei auf ein Elektron, das eine Energie von 10 keV hat, und die Elektrodenpotentiale den in der Tabelle 1 angegebenen Werten entsprechen.

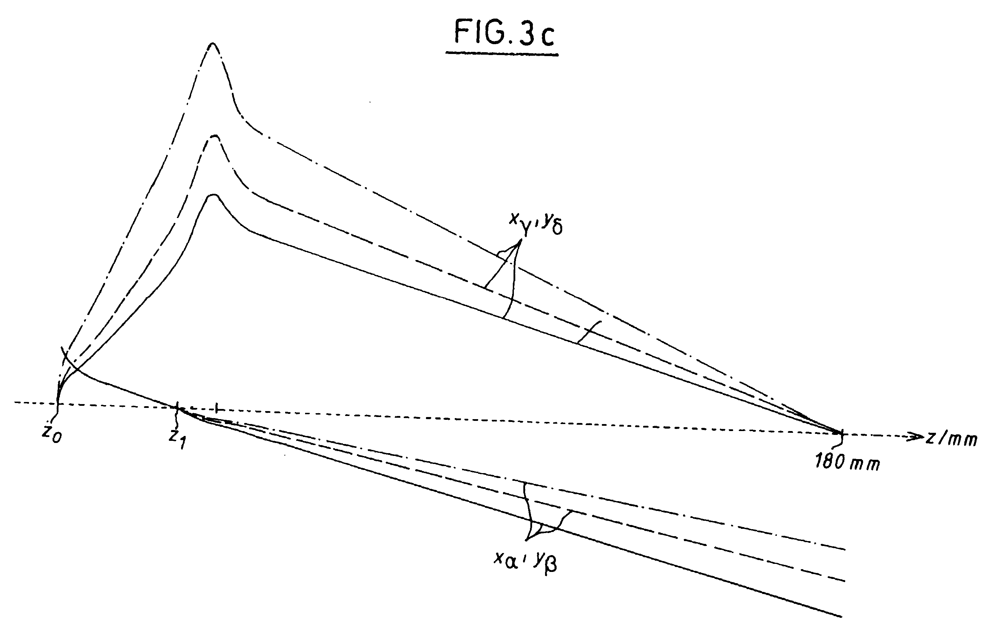

In der Figur 3c sind die (x_{α}, y_{β})-Bahnen und die (x_{χ}, y_{δ}) -Bahnen eines 10 kV-Elektrons bei drei unterschiedlichen Einstellungen der Potentiale (Φ₁, Φ₂, Φ₃, Φ₄) eingezeichnet. Die durchgezogenen Bahnen gehören zu der in Tabelle 1 angegebenen Potentialeinstellung. Bei einer Einstellung der Spannungen gemäß der Tabelle 2 ergeben sich die gestrichelt dargestellten Bahnen und bei einer Einstellung nach Tabelle 3 die strichpunktierten Bahnen. Aus den in den Tabellen 1-3 angegebenen Werten für die chromatische Aberration (C_{c}) erkennt man, daß sich der negative Farbfehler der elektrostatischen Spiegellinsenkombination (60) über einen großen Bereich durch Änderung der an den Elektroden anliegenden Potentialen einstellen läßt. Die Fehlerkoeffizienten (C_{c}) der chromatischen und (C_{ö}) der sphärischen Aberration beziehen sich dabei auf die Objektebene bei der ebenfalls in den Tabellen angegebenen Zwischenvergrößerungen (V).

Die sich entlang der (χ- und δ-Bahnen ausbreitenden Elektronen schneiden die optische Achse (z) bei allen Potentialeinstellungen an der selben Stelle (zₒ) und breiten sich anschließend auf einer zur Einfallsbahn bezüglich der optischen Achse (z) spiegelsymmetrischen Bahn aus. Die sich entlang der α-, β-Bahnen ausbreitenden Elektronen werden am Ende der α-, β-Bahnen in sich selbst reflektiert. Die α-, β-Bahnen schneiden die optische Achse (z) an der mit (z₁) gekennzeichneten Stelle. An dieser Stelle liegt eine virtuelle Zwischenbildebene vor. Die χ- und δ-Bahnen schneiden die optische Achse bei z = 180 mm. Hier liegt eine Beugungsebene vor, die beim Gesamtsystem mit den Symmetrieebenen (3g, 3h) des Umlenkers zusammenfällt.

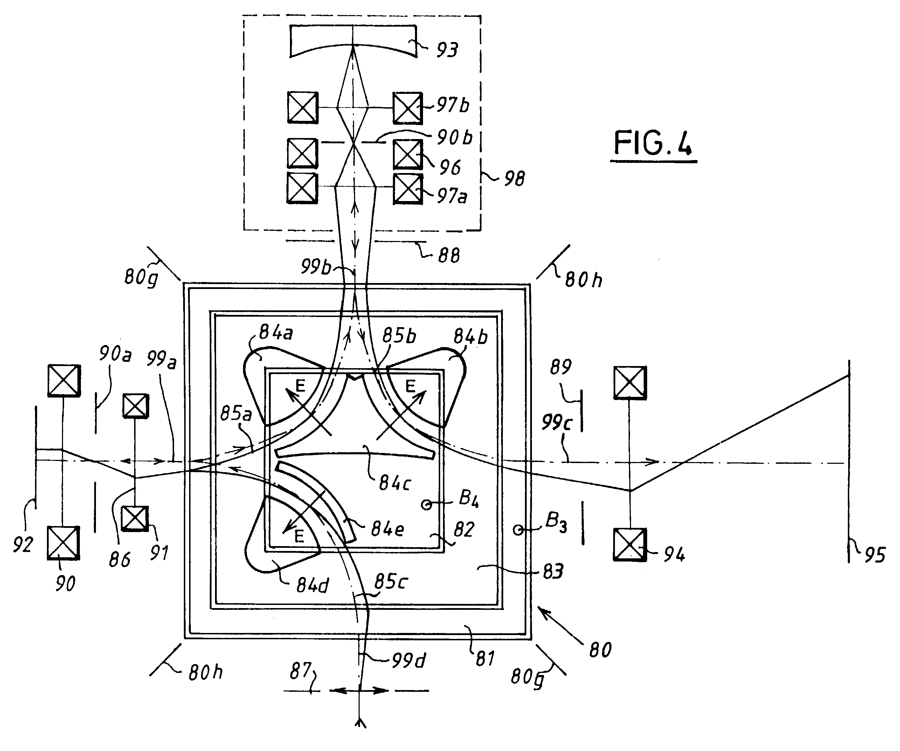

Das Abbildungssystem in Figur 4 hat einen dispersionsfreien Umlenker (80). Der Umlenker besteht aus äußeren Polschuhen (81) und inneren Polschuhen (82). Das Magnetfeld (B₄) zwischen den inneren Polschuhen (82) ist betragsmäßig doppelt so groß, wie das Magnetfeld (B₃) zwischen den äußeren Polschuhen (81). Die Richtung beider Magnetfelder (B₃, B₄) ist senkrecht zur Zeichenebene. Zwischen den inneren und den äußeren Polschuhen befindet sich ein Raum (83), der vorzugsweise magnetfeldfrei ist. Hier könnte prinzipiell auch noch ein drittes magnetisches Umlenkfeld eingeschaltet sein.

Dem inneren Magnetfeld (B₄) sind elektrische Felder (E) überlagert, die jeweils radial zur jeweiligen optischen Achse (85a-c) ausgerichtet sind. Zur Erzeugung der elektrischen Felder sind Elektroden (84a-e) vorgesehen. Die den optischen Achsen (85a-c) zugewandten Elektrodenflächen haben die Form von Zylindermänteln. Die an den Elektroden angelegte Spannung ist gerade so gewählt, daß die magnetische Ablenkung der Elektronenbahnen im inneren Magnetfeld (B₄) ungefähr zur Hälfte kompensiert ist. Dadurch wird erreicht, daß die Abbildung durch den Umlenker bereits beim einfachen Durchgang dispersionsfrei ist.

Der Umlenker (80) ist im Bereich der optischen Achse (85a) symmetrisch zur Diagonalebene (80g) und in den Bereichen der optischen Achsen (85b) und (85c) symmetrische zur zweiten Diagonalebene (80h).

Der Umlenker lenkt die entlang der optischen Achsen (85a-c) einfallenden Elektronen bei jedem Durchgang jeweils um 90 Grad ab. Dabei ist beleuchtungsseitig die Zwischenbildebene (87) einer nicht dargestellten Kondensorlinse in die Diagonalebene (80h) abgebildet. Eine vor einem Objektiv (90) angeordnete Feldlinse (91) bildet die Diagonalebene (80h) in die hintere Beugungsebene (90a) des Objektivs (90) ab. Gleichzeitig bildet die Feldlinse (91) die Beugungsebene (90ₐ) des Objektivs (90) in die Diagonalebene (80g) ab. Analog zur Fig. 1 ist diese Diagonalebene (80g) über den Spiegel (93) in die zweite Diagonalebene (80h) abgebildet, wobei ein Zwischenbild der Diagonalebenen (80g, 80h) im Spiegel (93) liegt. Ein Projektiv (94) erzeugt ein reelles Abbild des Objektes (92) in der Ebene (95). Der Umlenker selbst bildet die Zwischenbildebenen (86, 88, 89) stigmatisch und verzeichnungsfrei aufeinander ab.

Zur Einstellung der Brechkraft des Umlenkers (80) in der zur Zeichenebene senkrechten Richtung kann an die Elektroden (84a-c) noch ein konstantes Offset-Potential angelegt sein. Dadurch wird ein Quadrupolfeld erzeugt, das senkrecht zur Zeichenebene zusätzlich fokussierend oder defokussierend wirkt, je nachdem ob ein positives oder negatives Offset-Potential angelegt ist. Der Wert des Offset-Potentials (relativ zum Potential der Polschuhe (81, 82)) ist sogewählt, daß der Umlenker (80) in der Zeichenebene und in der zur Zeichen-ebene senkrechten Richtung die selbe Brechkraft hat.

Da die beobachtungsseitigen Strahlengänge im Bereich der optischen Achsen (85a, 85b) symmetrisch zu einer der Diagonalebenen (80g, 80h) verlaufen, heben sich die Fehler 2. Ordnung des Umlenkers (80) nach zweimaligem Durchgang gerade wieder auf. Der negative Farbfehler des Spiegels (93) ist gerade so eingestellt, daß der positive Farbfehler des Objektivs (90) kompensiert ist. Der gemeinsame Öffnungsfehler von Objektiv (90) und Spiegel (93) ist durch einen magnetischen Hexapol (96) kompensiert. Der Hexapol (96) ist dazu in einer zur Beugungsebene (90a) konjugierten Ebene (90b) angeordnet. Das Objekt (92) ist somit ohne Farb- und Öffnungsfehler vergrößert in die Ebene (95) abgebildet.

Da jeder einzelne Durchgang durch den Umlenker (80) dispersionsfrei ist, können auch keine Kombinationsfehler zwischen der Dispersion und dem Farb- oder Öffnungsfehler des Spiegels (93) auftreten. Daher ist das Abbildungssystem auch für ein großes Bildfeld bezüglich Farb- und Öffnungsfehler korrigiert.

Es ist noch zu bemerken, daß nicht unbedingt die Beugungsebene (90a) in die Diagonalebenen (80g, h) und in den Spiegel (93) abgebildet sein muß. Es ist vielmehr auch möglich, eine Zwischenbildebene in die Diagonalebenen abzubilden. Es entsteht dann ein reelles Zwischenbild des Objektes (92) im Spiegel (93). Der Hexapol muß dann so angeordnet sein, daß er wieder in einer Beugungsebene liegt. Aufgrund der vertauschten Bahnen ist dabei ein elektrostatischer Hexapol zu verwenden.

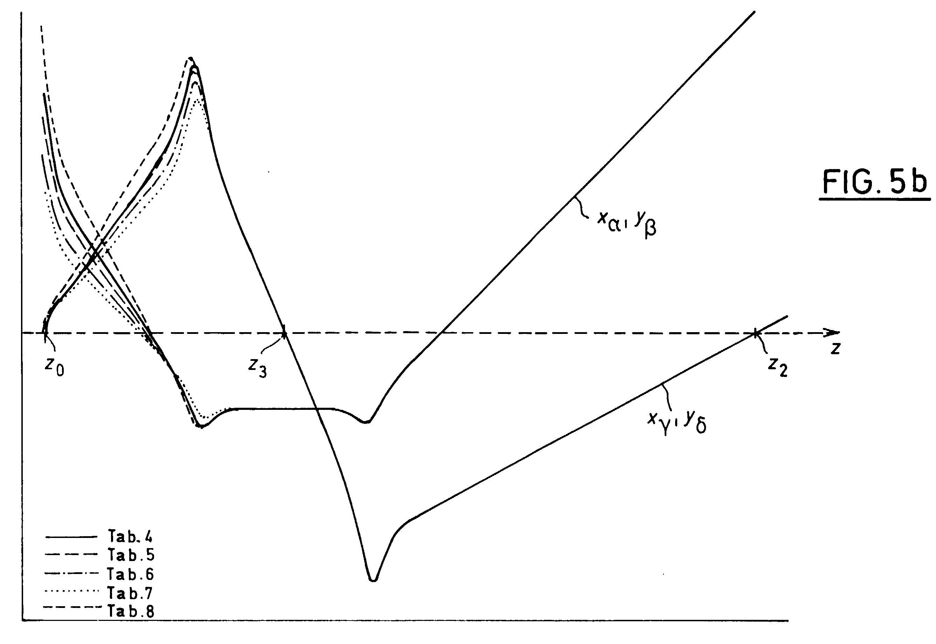

Das System aus Linsen (97a, b) und Spiegel (93) besteht vorzugsweise aus einem elektrostatischen Spiegel-Linsensystem (98), das anhand der Figuren 5a und 5b beschrieben ist.

Das elektrostatische Spiegel-Linsensystem aus Figur 5a hat sechs Elektroden (101 bis 106). Durch geeignete Wahl der Potentiale an den sechs Elektroden lassen sich die Abbildungseigenschaften sowohl auf unterschiedliche Abstände der Zwischenbild- und Beugungsebenen einstellen, als auch der Farbfehler und die Steigung der α-Bahn im Inneren der Spiegel-Linsenkombination. In einem Hohlraum der Elektrode (103) ist ein magnetischer Hexapol (107) zur Einstellung des Öffnungsfehlers angeordnet. Das Hexapolfeld wirkt durch die Wandung der Elektrode (103) hindurch. In der Fig. 5a ist zur Vereinfachung nur eine Hälfte der Spiegel-Linsenkombination (100) dargestellt. Die Elektroden (101-106) selbst sind jeweils rotationssymmetrisch zur optischen Achse (z).

In der Figur 5b sind die (x_{α}, y_{β}) und die (x_{χ}, y_{δ})-Bahnen für 10 keV-Elektronen bei den in den Tabellen 4-8 angegebenen Potentialen (Φ₁) bis (Φ₆) angegeben. Elektronen auf den (α, β)-Bahnen werden jeweils an der Stelle (Zₒ) in sich selbst reflektiert, während Elektronen auf den (χ,δ)-Bahnen auf einer zur z-Achse spiegelsymmetrischen (χ,δ)-Bahn umgelenkt werden.

Wie die Tabellen 4-8 zeigen, läßt sich der Farbfehler (C_{c}) der Spiegel-Linsenkombination über einen großen Bereich variieren. Durch Variation des Potentials (Φ₅), das in den Tabellen 4-8 fest ist und geeigneter Anpassung der Potentiale (Φ₁ bis Φ₄), läßt sich auch noch die Lage der bei (z₂) vorliegenden Beugungsebene variieren. Der magnetische Hexapol zur Einstellung des Öffnungsfehlers ist in der Nähe der bei (z₃) vorliegenden Beugungsebene angeordnet.

Die in den Tabellen 4-8 angegebenen Werte für den Öffnungsfehler (C_{ö}) und den Farbfehler (C_{c}) beziehen sich auf eine Objektebene bei der ebenfalls in den Tabellen angegebenen Zwischenvergrößerung. Das System aus Strahlumlenker und elektrostatischer Spiegel-Linsenkombination erlaubt daher die gleichzeitige Korrektur von Farb- und Öffnungsfehlern bei unterschiedlichen Objektiverregungen und daraus resultierenden unterschiedlichen Zwischenvergrößerungen.

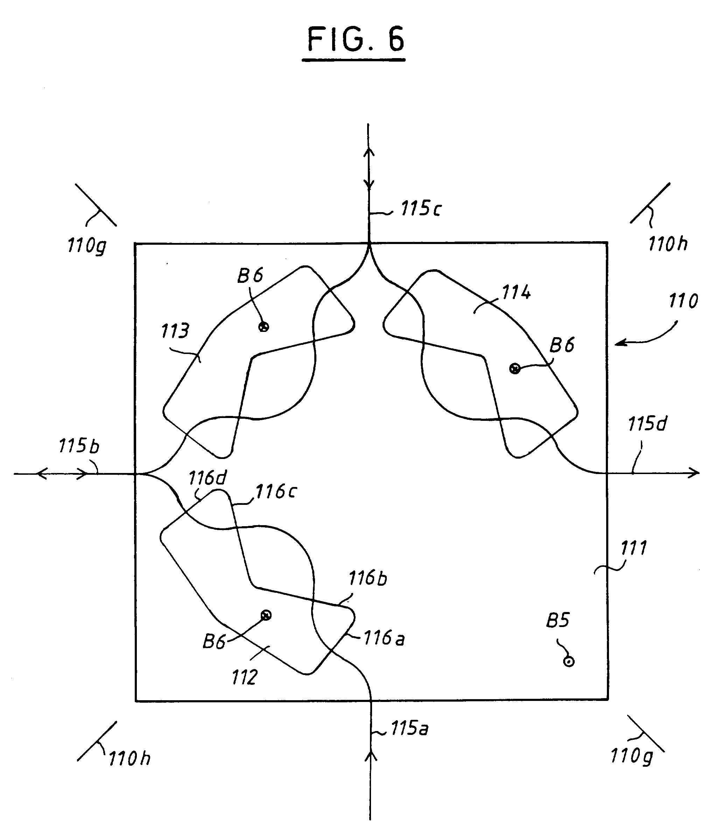

In der Figur 6 ist ein zweites Ausführungsbeispiel für einen bereits bei einfachem Durchgang dispersionsfreien Umlenker (110) dargestellt. Der Umlenker hat zwei äußere quadratische Polschuhe (111), zwischen denen ein zur Zeichenebene senkrechtes äußeres Magnetfeld (B₅) erzeugt ist. Im Inneren dieses Umlenkers sind drei weitere Polschuhpaare (112, 113, 114) angeordnet. Die Polschuhpaare (112 und 114) sind spiegelsymmetrisch zur ersten Diagonalebene (110h) und das Polschuhpaar (113) ist spiegelsymmetrisch zur zweiten Diagonalebene (110g) des Umlenkers. Zwischen den inneren Polschuhpaaren sind magnetische Ablenkfelder (B₆) erzeugt, die ebenfalls senkrecht zur Zeichenebene jedoch zum äußeren Ablenkfeld (B₅) entgegengerichtet sind. Der Betrag der inneren Ablenkfelder (B₆) ist ungefähr gleich dem Betrag des äußeren Ablenkfeldes (B₅).

Der Umlenker (110) lenkt die entlang der optischen Achsen (115a, 115b, 115c) einfallenden Elektronen jeweils insgesamt um 90° um. Dabei treten die Elektronen im Inneren des Umlenkers jeweils zweimal in die inneren Magnetfelder (B₆) ein und aus. Dazu sind die Ein- bzw. Austrittsflächen (116a, 116b, 116c, 116d) der inneren Umlenkfelder im wesentlichen M-förmig zueinander angeordnet. Die äußeren und inneren Magnetfelder (B₅, B₆) sind so eingestellt, daß die Elektronenbahnen in jedem der drei benutzten Quadranten des Umlenkers (110) jeweils symmetrisch zu einer der Diagonalebenen (110g, 110h) verlaufen, und daß aufgrund der entgegengesetzten Umlenkungen im inneren und äußeren Magnetfeld jede 90°-Umlenkung dispersionsfrei erfolgt. Die Elektronenbahnen treten dabei jeweils unter einem von 90° abweichenden Winkel in die inneren Magnetfelder (B₆) ein bzw. aus. Dadurch werden jeweils Quadropolfelder wirksam, die eine Fokussierung der Elektronenbahnen senkrecht zur Zeichenebene bewirken.

Abgesehen davon, daß bei diesem Umlenker lediglich magnetische Umlenkfelder erforderlich sind und der Aufbau relativ zu dem Umlenker aus Figur 4 vereinfacht ist, haben beide Umlenker (80, 110) äquivalente Abbildungseigenschaften. Die Anordnung des Umlenkers (110) innerhalb des Elektronen-Mikroskopes ist völlig analog zum Umlenker aus Figur 4, so daß auf die weiteren Details hinsichtlich der Abbildung der Bild- und Beugungsebenen in die Symmetrieebenen (110g, 110h) nicht noch einmal eingegangen zu werden braucht.

**Tabelle 1:**

| | |
|---|---|
| Φ₁ = | - 4,243 kV |
| Φ₂ = | + 15,847 kV |
| Φ₃ = | + 3,212 kV |
| Φ₄ = | + 10 kV |
| | |
| C_{c} = | - 10 mm |
| C_{ö} = | 1,39 mm |
| V = | 10 |

**Tabelle 2:**

| | |
|---|---|
| Φ₁ = | - 2,411 kV |
| Φ₂ = | + 8,929 kV |
| Φ₃ = | + 2,351 kV |
| Φ₄ = | + 10 kV |
| | |
| C_{c} = | - 20 mm |
| C_{ö} = | + 2,36 mm |
| V = | 10 |

**Tabelle 3:**

| | |
|---|---|
| Φ₁ = | - 1,112 kV |
| Φ₂ = | + 4,091 kV |
| Φ₃ = | + 2,087 kV |
| Φ₄ = | + 10 kV |
| | |
| C_{c} = | - 50 mm |
| C_{ö} = | + 4,54 mm |
| V = | 10 |

**Tabelle 4:**

| | |
|---|---|
| Φ₁ = | - 1,382 kV |
| Φ₂ = | + 4,946 kV |
| Φ₃ = | + 0,732 kV |
| Φ₄ = | + 8,127 kV |
| Φ₅ = | + 1,553 kV |
| Φ₆ = | + 10 kV |
| | |
| C_{c} = | - 6,4 mm |
| C_{ö} = | - 0,1 mm |
| V = | 23,9 |

**Tabelle 5:**

| | |
|---|---|
| Φ₁ = | - 1,856 kV |
| Φ₂ = | + 6,686 kV |
| Φ₃ = | + 0,807 kV |
| Φ₄ = | + 8,127 kV |
| Φ₅ = | + 1,553 kV |
| Φ₆ = | + 10 kV |
| | |
| C_{c} = | - 13,5 mm |
| C_{ö} = | - 0,9 mm |
| V = | 13,3 |

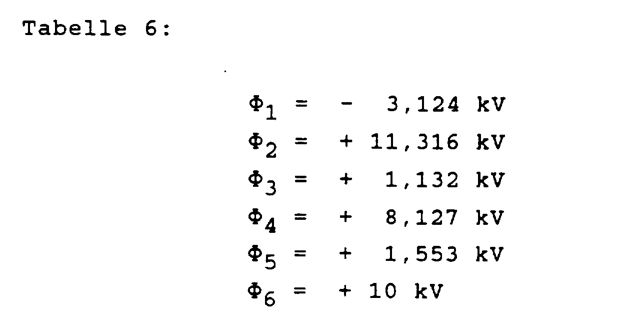

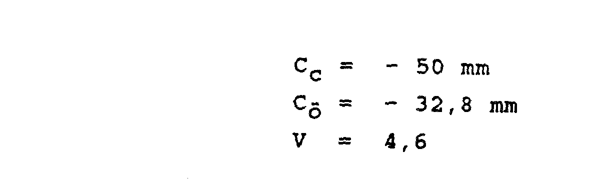

**Tabelle 7:**

| | |
|---|---|
| Φ₁ = | - 5,716 kV |
| Φ₂ = | + 22,236 kV |
| Φ₃ = | + 2,104 kV |
| Φ₄ = | + 8,126 kV |
| Φ₅ = | + 1,553 kV |
| Φ₆ = | + 10 kV |
| | |
| C_{c} = | - 2 mm |
| C_{ö} = | - 0,2 mm |
| V = | 13,3 |

**Tabelle 8:**

| | |
|---|---|
| Φ₁ = | - 0,708 kV |
| Φ₂ = | + 2,505 kV |
| Φ₃ = | + 0,732 kV |
| Φ₄ = | + 8,127 kV |
| Φ₅ = | + 1,553 kV |
| Φ₆ = | + 10 kV |
| | |
| C_{c} = | - 50 mm |
| C_{ö} = | - 2,4 mm |
| V = | 13,3 |

## Patentansprüche

1. Abbildungssystem für Strahlung geladener Teilchen, insbesondere in einem Teilchenstrahlenmikroskop, mit einem im Strahlengang angeordneten Umlenker, der in einem ersten Bereich eine Umlenkung symmetrisch zu einer ersten Symmetrieebene und mindestens in einem zweiten Bereich eine Umlenkung symmetrisch zu einer zweiten Symmetrieebene bewirkt, und einem nach dem ersten Bereich hinter dem Umlenker angeordneten elektrostatischen Spiegel, dadurch gekennzeichnet, daß der elektrostatische Spiegel (5; 60; 93; 100) konjugiert zu den beiden Symmetrieebenen (3g, 3h; 80g, 80h; 110g, 110h) des Umlenkers (3; 80; 110) angeordnet ist und die beiden Symmetrieebenen (3g, 3h; 80g, 80h; 110g, 110h) im Abbildungsmaßstab 1:1 aufeinander abgebildet sind.

2. Abbildungssystem nach Anspruch 1, dadurch gekennzeichnet, daß der elektrostatische Spiegel (5; 93) eine elektrostatische Spiegel-Linsenkombination (60; 98; 100) ist oder zwischen dem Umlenker (3; 80; 110) und dem elektrostatischen Spiegel (5; 93) ein Magnetlinsensystem (8a, 8b; 97a, 97b) angeordnet ist.

3. Abbildungssystem nach Anspruch 2, dadurch gekennzeichnet, daß der Umlenker (3; 80; 110) den Teilchenstrahl bei jedem Durchgang jeweils um betragsmäßig gleiche Ablenkwinkel ablenkt.

4. Abbildungssystem nach Anspruch 3, dadurch gekennzeichnet, daß die Symmetrieebenen (3g, 3h; 80g, 80h; 110g, 110h) die optische Achse (11, 99b) der elektrostatischen Spiegel-Linsenkombination (18; 98) oder des Magnetlinsensystems (8a, 8b; 97a, 97b) im halben Ablenkwinkel schneiden.

5. Abbildungssystem nach einem der Ansprüche 2-4, dadurch gekennzeichnet, daß der Umlenkwinkel jeweils 90° beträgt.

6. Abbildungssystem nach Anspruch 1, dadurch gekennzeichnet, daß im Strahlumlenker (3; 80; 110) ein erstes äußeres magnetisches (B₁; B₃; B₅) und mindestens ein zweites magnetisches Ablenkfeld (B₂; B₄; B₆) erzeugt sind.

7. Abbildungssystem nach Anspruch 6, dadurch gekennzeichnet, daß die Eintritts- und Austrittsebenen (3a, 3b, 3c, 3d) des äußeren magnetischen Feldes (B₁; B₃; B₅) jeweils senkrecht zur optischen Ein-Ausfallsachse (4, 11, 12; 99a-d; 115a-d) liegende ebene Flächen bilden.

8. Abbildungssystem nach einem der Ansprüche 1 bis 7, dadurch gekennzeichnet, daß die Symmetrieebenen (3g, 3h; 80g, 80h; 110g, 110h) zu Zwischenbildebenen oder zur Beugungsebene (15; 90a) eines Objektivs (2; 90) konjugierte Ebenen sind.

9. Abbildungssystem nach Anspruch 8, dadurch gekennzeichnet, daß genau zwei gleichgerichtete magnetische Ablenkfelder (B₁, B₂) erzeugt sind, und daß die Symmetrieebenen (3g, 3h) zur Beugungsebene (15) eines Objektivs (2) konjugierte Ebenen sind.

10. Abbildungssystem nach Anspruch 8, dadurch gekennzeichnet, daß im Strahlumlenker (80) mindestens zwei magnetische Ablenkfelder (B₃, B₄) und zusätzliche elektrostatische Ablenkfelder (E) erzeugt sind.

11. Abbildungssystem nach Anspruch 8, dadurch gekennzeichnet, daß im Strahlumlenker (110) ein äußeres Magnetfeld (B₅) und drei betrags- und richtungsmäßig gleiche innere Magnetfelder (B₆) vorgesehen sind.

12. Abbildungssystem nach Anspruch 11, dadurch gekennzeichnet, daß die Ein- und Austrittsflächen (116a-d) der inneren Magnetfelder (B₆) M-förmig angeordnet sind, und daß der Teilchenstrahl bei jeder Umlenkung zweimal in das innere Magnetfeld ein- und austritt.

13. Abbildungssystem nach einem der Ansprüche 1-12, dadurch gekennzeichnet, daß in einer zur Beugungsebene (15; 90a) eines Objektivs (2; 90) konjugierten Ebene (7; 90b) ein Hexapolelement (18; 96) angeordnet ist.

14. Abbildungssystem nach einem der Ansprüche 8-12, dadurch gekennzeichnet, daß das elektrostatische Spiegellinsensystem (60) mindestens vier Elektroden (61-64) hat.

15. Abbildungssystem nach Anspruch 1, dadurch gekennzeichnet, daß der Strahlumlenker (80; 110) gleichzeitig zur Trennung von Beleuchtungs- (85c; 115a) und Beobachtungsstrahlengang (85a; 115b) dient.

## Claims

1. Imaging system for radiation of charged particles, especially in a particle beam microscope, having a deflector mounted in the beam path which, in a first region, effects a deflection symmetrically to a first symmetry plane and at least, in a second region, effects a deflection symmetrically to a second symmetry plane and an electrostatic mirror arranged downstream of the first region behind the deflector, characterized in that the electrostatic mirror (5; 60; 93; 100) is arranged conjugated to both symmetry planes (3g, 3h; 80g, 80h; 110g, 110h) of the deflector (3; 80; 110) and that both symmetry planes (3g, 3h; 80g, 80h; 110g, 110h) are imaged one onto the other with an imaging scale of 1:1.

2. Imaging system of claim 1, characterized in that the electrostatic mirror (5; 93) is an electrostatic mirror lens combination (60; 98; 100) or that a magnetic lens system (8a, 8b; 97a, 97b) is arranged between the deflector (3; 80; 110) and the electrostatic mirror (5; 93).

3. Imaging system of claim 2, characterized in that the deflector (3; 80; 110) deflect the particle beam at each passthrough each time at angles having the same absolute value of magnitude.

4. Imaging system of claim 3, characterized in that the symmetry planes (3g, 3h; 80g, 80h; 110g, 110g) intersect the optical axis (11, 99b) of the electrostatic mirror lens combination (18; 98) or of the magnetic lens system (8a, 8b; 97a, 97b) at half the deflection angle.

5. Imaging system of one of the claims 2 to 4, characterized in that the deflection angle has a value of 90°.

6. Imaging system of claim 1, characterized in that a first outer magnetic deflection field (B₁; B₃; B₅) and at least a second magnetic deflection field (B₂; B₄; B₆) are generated within the deflector (3; 80; 110).

7. Imaging system of claim 6, characterized in that the entry and exit planes (3a, 3b, 3c, 3d) of the outer magnetic field (B₁; B₃; B₅) define surfaces each disposed perpendicularly to the entry and exit optical axis (4, 11, 12; 99a-d; 115a-d).

8. Imaging system of one of the claims 1 to 7, characterized in that the symmetry planes (3g, 3h; 80g, 80h; 110g, 110h) are planes conjugated to intermediate image planes or to a diffraction plane (15; 90a) of an objective (2; 90).

9. Imaging system of claim 8, characterized in that exactly to magnetic deflection fields (B₁, B₂) having the same direction are generated and that the symmetry planes (3g, 3h) are planes conjugated to the diffraction plane (15) of an objective (2).

10. Imaging system of claim 8, characterized in that at least to magnetic deflection fields (B₃, B₄) and additional electrostatic deflection fields (E) are generated in the deflector (80).

11. Imaging system of claim 8, characterized in that an outer magnetic field (B₅) and three inner magnetic fields (B₆) of same magnitude and direction are provided in the deflector (110).

12. Imaging system of claim 11, characterized in that the entry and exit planes (116a-d) of the inner magnetic fields (B₆) are arranged in an M-configuration and that the particle beam enters and leaves the inner magnetic field twice at each paththrough.

13. Imaging system of one of the claims 1 to 12, characterized in that a hexapole element (18; 96) is arranged in a plane (7; 90b) conjugated to the diffraction plane (15; 90a) of the objective (2; 90).

14. Imaging system of one of the claims 8 to 12, characterized in that the electrostatic mirror lens combination (60) comprises at least for electrodes (61-64).

15. Imaging system of claim 1, characterized in that the beam deflector (80; 110) simultaneously serves for separating the illumination beam path (85c; 115a) and the observation beam path (85a; 115b).

## Revendications

1. Système de reproduction d'un rayonnement de particules chargées destiné notamment à un microscope à rayonnement corpusculaire, doté d'un déflecteur disposé dans le trajet des rayons qui provoque, dans une première zone, une déflexion symétrique par rapport à un premier plan de symétrie et, dans une deuxième zone au moins, une déflexion symétrique par rapport à un deuxième plan de symétrie, ainsi que d'un miroir électrostatique disposé en aval de la première zone, derrière ledit déflecteur, caractérisé en ce que le miroir électrostatique (5; 60; 93; 100) est conjugué aux deux plans de symétrie (3g, 3h, 80g, 80h; 110g, 110h) du déflecteur (3; 80; 110) et que les deux plans de symétrie (3g, 3h, 80g, 80h; 110g, 110h) sont reproduits les uns sur les autres à une échelle de reproduction de 1 : 1.

2. Système de reproduction selon la revendication 1, caractérisé en ce que le miroir électrostatique (5; 93) est une combinaison électrostatique miroir-lentille (60; 98; 100) ou qu'un système de lentilles magnétiques (8a, 8b; 97a, 97b) est disposé entre le déflecteur (3; 80; 110) et le miroir électrostatique (5; 93).

3. Système de reproduction selon la revendication 2, caractérisé en ce que le déflecteur (3; 80; 110) défléchit le faisceau corpusculaire à chaque passage respectivement d'un angle de déflexion de montant égal.

4. Système de reproduction selon la revendication 3, caractérisé en ce que les plans de symétrie (3g, 3h; 80g, 80h; 110g, 110h) coupent l'axe optique (11, 99b) de la combinaison électrostatique miroir-lentille (18; 98) ou du système de lentilles magnétiques (8a, 8b; 97a, 97b) à la bissectrice de l'angle de déflexion.

5. Système de reproduction selon l'une des revendications 2 à 4, caractérisé en ce que l'angle de déflexion est de 90° respectivement.

6. Système de reproduction selon la revendication 1, caractérisé en ce qu'un premier champ magnétique de déflexion extérieur (B₁, B₃, B₅) et au moins un deuxième champ magnétique de déflexion (B₂, B₄, B₆) sont générés dans le déflecteur de faisceau (3; 80; 110).

7. Système de reproduction selon la revendication 6, caractérisé en ce que les plans d'entrée et de sortie (3a, 3b, 3c, 3d) du champ magnétique extérieur (B₁, B₃, B₅) forment respectivement des surfaces planes perpendiculaires à l'axe optique d'entrée et de sortie (4, 11, 12; 99a-d; 115a-d).

8. Système de reproduction selon l'une des revendications 1 à 7, caractérisé en ce que les plans de symétrie (3g, 3h; 80g, 80h; 110g, 110h) sont conjugués à des plans d'image intermédiaire ou au plan d'image de diffraction (15, 90a) d'un objectif (2; 90).

9. Système de reproduction selon la revendication 8, caractérisé en ce que deux champs magnétiques de déflexion (B₁, B₂) de même orientation sont générés très exactement et que les plans de symétrie (3g, 3h) sont conjugués au plan d'image de diffraction (15) d'un objectif (2).

10. Système de reproduction selon la revendication 8, caractérisé en ce que deux champs magnétiques de déflexion (B₃, B₄) au moins et des champs de déflexion électrostatiques complémentaires (E) sont générés dans le déflecteur de faisceau (80).

11. Système de reproduction selon la revendication 8, caractérisé en ce qu'un champ magnétique extérieur (B₅) et trois champs magnétiques intérieurs égaux par leur montant et par leur orientation (B₆) sont prévus dans le déflecteur de faisceau (110).

12. Système de reproduction selon la revendication 11, caractérisé en ce que les faces d'entrée et de sortie (116a-d) des champs magnétiques intérieurs (B₆) sont disposées en forme de M et que le faisceau corpusculaire entre dans le champ magnétique intérieur et en ressort deux fois respectivement à chaque déflexion.

13. Système de reproduction selon l'une des revendications 1 à 12, caractérisé en ce qu'un élément hexapolaire (18; 96) est disposé dans un plan (7; 90b) conjugué au plan d'image de diffraction (15, 90a) d'un objectif (2; 90).

14. Système de reproduction selon l'une des revendications 8 à 12, caractérisé en ce que le système électrostatique miroir-lentille (60) comprend au moins quatre électrodes (61-64).

15. Système de reproduction selon la revendication 1, caractérisé en ce que le déflecteur de faisceau (80; 110) sert en même temps à séparer le trajet des rayons d'éclairage (85c; 115a) du trajet des rayons d'observation (85a; 115b).
